**Europäisches Patentamt**

**European Patent Office**

**Office européen des brevets**

(19)

(11) Veröffentlichungsnummer: **0 505 938 A1**

# (12) EUROPÄISCHE PATENTANMELDUNG

(21) Anmeldenummer: **92104866.6**

(22) Anmeldetag: **20.03.92**

(51) Int. Cl.5: **G11B 33/12**, G06F 1/16, H05K 7/14

(30) Priorität: **26.03.91 DE 9103692 U**

(43) Veröffentlichungstag der Anmeldung:
**30.09.92 Patentblatt 92/40**

(84) Benannte Vertragsstaaten:
**AT BE CH DE DK ES FR GB IT LI LU NL SE**

(71) Anmelder: **Tappert, Karl-Heinz**
**Götscherweg 79a**
**W-4018 Langenfeld(DE)**

(72) Erfinder: **Tappert, Karl-Heinz**
**Götscherweg 79a**
**W-4018 Langenfeld(DE)**

(74) Vertreter: **Stratmann, Ernst, Dr.-Ing.**
**Schadowplatz 9**
**W-4000 Düsseldorf 1(DE)**

(54) **Computergehäuse, insbesondere Einschubgehäuse mit türartiger Zugangsabdeckung.**

(57) Es wird ein Computergehäuse (10), insbesondere Einschubgehäuse (12) beschrieben, mit türartiger Zugangsabdeckung (24) für ein Datenspeicherlaufwerk (34), wobei die türartige Zugangsabdeckung (24) aus einer im wesentlichen rechteckigen Platte besteht, die parallel zu einer Rechteckkante am Computergehäuse angelenkt ist und einer anderen, insbesondere der gegenüberliegenden Kante einrastbar oder verriegelbar (56) ist. Erfindungsgemäß ist das Datenspeicherlaufwerk oder dgl. mit einem im wesentlichen flachen, rechteckigen Kasten (34) untergebracht, wobei der Einführschlitz (60) für das Speichermedium wie Diskette an der von der Anlenkung zur Seite abgewandten Seite (40) vorgesehen ist und daher bereits bei geringfügiger Öffnung der türartigen Abdeckung (24) zugänglich wird, andererseits bei geschlossener türartiger Abdeckung (24) dieser Spalt gegen Staubeinfall u. ä. sowie auch gegen unautorisierte Verwendung geschützt ist.

Die türartige Abdeckung kann auch zusätzlich oder allein ein Bedienungs- oder Anzeigefeld (42) tragen.

Fig.2.

EP 0 505 938 A1

Rank Xerox (UK) Business Services

Die Erfindung betrifft ein Computergehäuse, insbesondere ein Einschubgehäuse mit türartiger Zugangsabdeckung für ein Datenspeicherlaufwerk oder dgl., wobei die türartige Zugangsabdeckung aus einer im wesentlichen rechteckigen Platte besteht, die an einer Rechteckkante am Computergehäuse, insbesondere Frontseite eines Einschubgehäuses, ausschwenkbar angelenkt ist, und an einer anderen, wie gegenüberliegenden Kante am Computergehäuse einrastbar oder verriegelbar ist.

Ein derartiges Computergehäuse ist aus der Gebrauchsmusterschrift G 90 00 854.5 des Anmelders der vorliegenden Gebrauchsmusteranmeldung bereits bekannt.

Das bekannte Computergehäuse weist bereits viele Vorzüge auf, ist jedoch noch weiter verbesserbar, insbesondere in der Hinsicht, daß die Frontseite eines derartigen Gehäuses, die z. B. bei Einschubgehäusen als einzige für den Benutzer während des Betriebes zugänglich ist, noch besser für die Anordnung solcher Bauteile und Baugruppen nutzbar ist, die während des Betriebes zugänglich sein müssen, ohne daß dabei die Frontflächengröße zu diesem Zweck vergrößert werden müßte.

Ein häufig vorhandenes Bauelement ist ein Laufwerk, das üblicherweise ständig zugänglich sein muß, andererseits aber gegenüber äußeren Umwelteinflüssen, wie Staub oder unautorisierte Manipulation, empfindlich ist und daher geschützt werden muß. Bisher geschah dieses dadurch, daß das Laufwerk (vorzugsweise für "Floppy-Disk" Speichermedien, alternativ aber auch z. B. für Magnetbandkassetten) so angeordnet ist, daß ein entsprechender Zufuhrschlitz für das Laufwerkmedium an der Frontfläche vorgesehen ist, welcher Schlitz zum einen verhältnismäßig viel Platz auf der Frontplatte beansprucht, zum anderen eine Abdeckung haben muß, um zu verhindern, daß durch diesen Schlitz hindurch Staub oder sonstige störende Gegenstände eindringen und im Laufwerk Störungen verursachen. Bei dem eingangs genannten Stand der Technik geschieht der Schutz dadurch, daß vor dem Laufwerkschlitz eine türartige Zugangsabdeckung vorgesehen ist.

Die bisherige Anordnung der Laufwerke, die eine erhebliche Erstreckung aufweisen, nimmt außerdem verhältnismäßig viel Tiefenraum innerhalb des Gehäuses in Anspruch und schränkt so die Anordnung anderer Gegenstände innerhalb des Gehäuses ein.

Aufgabe der Erfindung ist es, die oben geschilderten Probleme zu beseitigen und insbesondere eine Konstruktion zu schaffen, bei der empfindliche Anordnungen, wie beispielsweise ein Laufwerk, einerseits in ähnlicher Weise wie bisher geschützt werden können, andererseits aber erheblich weniger Platz sowohl hinsichtlich der Frontplattenfläche wie auch hinsichtlich der in das Computergehäuse hineinreichenden Raumerstreckung benötigen.

Gelöst wird die Aufgabe dadurch, daß das Datenspeicherlaufwerk oder dgl. einen im wesentlichen flachen, rechteckigen Kasten mit einem Einführschlitz für die Diskette oder dgl. bildet, daß der Kasten auf der Hinterfläche der türartigen Zugangsabdeckung angeordnet oder diese türartige Zugangsabdeckung von dem Kasten selbst gebildet wird, und daß der Einführschlitz an einer von der angelenkten Seite der Abdeckung abgewandten, vorzugsweise an der gegenüberliegenden Seite angeordnet ist.

Auf diese Weise werden mehrere Vorteile gleichzeitig erreicht: Zum einen wird durch die andere Anordnung dieses verhältnismäßig flachen Datenspeicherlaufwerkes (oder eines entsprechenden anderen Bauteils ähnlicher Abmessungen) innerhalb der Gehäusetiefe viel Platz gelassen, so daß das Gehäuse insgesamt mehr Bauteile aufnehmen kann, zum anderen wird erreicht, daß die Abdeckung des Einführungsschlitzes für die Diskette (oder eine entsprechende andere staubempfindliche Öffnung einer elektronischen Anordnung für das Computergehäuse) in Betriebsstellung nach außen hin abgeschlossen ist, so daß Staub o. ä. während des Betriebes (oder auch in Ruhezeiten, wenn der Einführschlitz nicht zugänglich sein muß) nicht eindringen kann.

Gemäß einer Weiterbildung der Erfindung ist die Anlenkungsachse der Abdeckung parallel und nahe zu einer der Vertikalfrontkanten angeordnet und der Einführungsschlitz liegt parallel zu dieser Achse und ist von dieser weggerichtet. Auf diese Weise ist eine besonders bequeme Zugangsmöglichkeit zu dem Schlitz gegeben.

Gemäß einer anderen Weiterbildung der Erfindung ist die türartige Abdeckung zumindest um einen solchen Winkel um die Anlenkachse aus einer zur Gehäusefrontfläche parallelen Stellung ausschwenkbar, so daß der Schlitz vor der Gehäuseaußenebene zu liegen kommt. Eine solche Stellung reicht bereits aus, um ein Speichermedium oder dgl. in den Schlitz einzuführen und anschließend die Tür wieder zu schließen. Dieser Winkel kann verhältnismäßig klein bleiben und es ist daher möglich, andere Geräte relativ nahe an die Frontfläche heranzustellen, ohne daß das Ausschwenken der Tür um diesen geringen Winkel behindert wird.

Auf der Außenfläche der Abdeckung können auch Bedienungs- und/oder Anzeigeeinrichtungen angeordnet sein, wie ein Leucht- oder Tastenfeld, so daß eine doppelte Nutzung erreicht wird: Zum einen wird die Frontfläche in diesem Bereich von dem Laufwerk genutzt, zum anderen von dem Leucht- oder Tastenfeld.

Die Vorteile der Anbringung von Leuchten oder Tasten auf der Abdeckung kommen auch dann zum Tragen, wenn, wie beim Stand der Technik, das Gehäuse mit einem Datenspeicherlaufwerk oder dgl. versehen ist, das in üblicher Weise angeordnet ist. Somit wird auch ein Computergehäuse gemäß der eingangs genannten Art als weitere Ausbildung beansprucht, bei der die Außenfläche der türartigen Abdeckung (die in diesem Falle nicht unbedingt das Datenspeicherlaufwerk selbst trägt) insofern zusätzlich genutzt wird, als diese türartige Abdeckung Bedienung- und/oder Anzeigeeinrichtungen wie ein Leucht- oder Tastenfeld trägt. Durch diese Maßnahmen vergrößert sich die Bedienungsfläche der Frontplatte, insbesondere dann, wenn neben der Frontfläche für die Abdeckung auch ggf. die Rückseite dieser Abdeckung für die Anbringung weiterer, nicht so häufig benutzter Bedienungseinrichtungen genutzt wird, ggf. zusätzlich noch zu der Fläche, die von der Abdeckplatte abgedeckt wird, da der einzige Schlitz für die Diskette meistens keinen so großen Flächenraum einnimmt. So sind beim Stand der Technik auf dieser von der türartigen Abdeckung geschützten Fläche ebenfalls Bedienungselemente neben dem Einführungsschlitz für das Datenspeicherlaufwerk vorhanden.

Somit vergrößert sich durch diese erfindungsgemäße Anordnung die nutzbare Frontfläche um das ein- bis zweifache der Fläche, die von der Abdeckung (nämlich deren Vorder- und Rückseite) gebildet wird.

Damit ergibt sich eine optimale Raumausnutzung und gestattet es, auch bei sehr kleinen Frontflächen, wie sie bei Einschubgehäusen manchmal vorkommen, notwenige Bedienungs- und Anzeigeelemente vorzusehen.

Gemäß einer weiteren Ausführungsform kann das Tastenfeld insbesondere von Folientasten gebildet werden, was den Vorteil hat, daß das Tastenfeld nur sehr wenig Raum beansprucht und nur sehr wenig über die tragende Platte der türartigen Zugangsabdeckung hinausragt.

Auf der Rückseite dieser türartigen Abdeckung kann ein (oder mehrere) Befestigungswinkel zur Befestigung von Laufwerken oder dgl. angeordnet sein. Mittels derartiger Befestigungswinkel kann die türartige Abdeckung an einem Rahmen oder an einem Gehäuse angelenkt sein. Dadurch erfüllen diese Befestigungswinkel die doppelte Funktion des Festhaltens von auf der türartigen Abdeckung zu befestigenden Gegenständen wie auch die Funktion des Anlenkens der türartigen Abdeckung an das Gehäuse selber.

Als besonders günstig hat sich erwiesen, wenn die Befestigungswinkel über den einen Rand der türartigen Abdeckung hinausreichen (und ggf. durch einen (jeweiligen) Durchbruch oder Einsenkung einer vom Rahmen oder Gehäuse gebildeten, die Anlenkungsgrundlage bildenden Seitenwand hindurchreichen) und an ihrem (ggf. hindurchreichenden) Ende an von der Seitenwand ausgehenden Anlenkwinkel angelenkt sind. Durch diese Konstruktion vergrößert sich die für an der türartigen Abdeckung zu befestigenden Einrichtungen zur Verfügung stehende Fläche.

Außerdem hat diese Konstruktion den Vorteil, daß auf einfache Weise ein Ausschwenkungsanschlag gebildet werden kann, indem beim Verschwenken der angelenkten Abdeckplatte um einen bestimmten Öffnungswinkel in Öffnungsrichtung die durch den Durchbruch hindurchreichende Befestigungswinkelerstreckung an einen Rand der Wand, die die Anlenkungsgrundlage bildet, z. B. an einem Durchbruchrand anschlägt.

Der Rahmen oder das Gehäuse kann kastenartig sein, wobei die Außenfläche des Kastenbodens vorzugsweise Befestigungswinkel zum Befestigen des insgesamt dadurch gebildeten Gehäuses in einem größeren Gehäuse, z. B. Einschubgehäuse, ermöglicht wird. Dadurch ergibt sich somit ein Gehäuse in einem anderen Gehäuse, das wiederum in einem dritten Gehäuse oder Rahmengestell untergebracht sein mag.

Die Außenfläche des Kastenbodens kann mit angenieteten Gewindehülsen versehen sein, die kürzer sind als die von der Außenfläche des Kastenbodens vorspringenden Teile der Befestigungswinkel, wodurch es möglich wird, vorzugsweise zwischen zwei nahe zweier sich gegenüberliegender Kastenrändern angeordneten Befestigungswinkeln eine Printplatte derart zu befestigen, daß sie noch von den vorspringenden Befestigungswinkeln überragt wird, einschließlich der auf den Printplatten angeordneten Bauteile, um diese so zu schützen.

Die Befestigungswinkel sind vorzugsweise langgestreckt und tragen an einem ihrer Längsenden eine zu den beiden Winkelschenkeln quer verlaufende Abschlußwand, an der sich ein Durchbruch für einen Befestigungsbolzen befindet. Dadurch kann die Gesamtanordnung auch hochkant montiert werden. Setzt man die Ebene der Abschlußwand jeweils jenseits der Kastenseiten, ergibt sich ein zusätzlicher Abstand des Kastens von der Befestigungsfläche, was Vorteile haben kann.

Die Erfindung wird nachfolgend anhand von Ausführungsbeispielen näher erläutert, die in den Zeichnungen dargestellt sind.

Es zeigt:

Fig. 1      in einer perspektivischen Darstellung ein erfindungsgemäß ausgestaltetes Computergehäuse;

Fig. 2      das Computergehäuse gemäß Fig. 1 mit teilweise herausgeklappter türartiger Zugangsabdeckung;

Fig. 3      eine Ansicht von oben auf das Computergehäuse gemäß Fig. 1 und 2;

Fig. 4 eine Ansicht von oben auf eine andere Ausführungsform eines erfindungsgemäß ausgestalteten Computergehäuses;

Fig. 5 in einer Teilansicht eine ähnliche Darstellung wie Fig. 4, jedoch mit einer anders ausgeführten türartigen Abdeckkung, die in einem eigenen Rahmen oder Gehäuse gelagert ist, die ihrerseits wieder in einem Computergehäuse untergebracht werden kann, wobei die türartige Abdeckung in der Darstellung gemäß Fig. 5 soweit ausgeschwenkt ist, wie es die Anschläge zulassen; und

Fig. 6 in einer Ansicht von rechts die türartige Abdeckung gemäß Fig. 5 einschließlich zugehörigem Rahmen, in der bis zum Anschlag ausgeschwenkten Stellung.

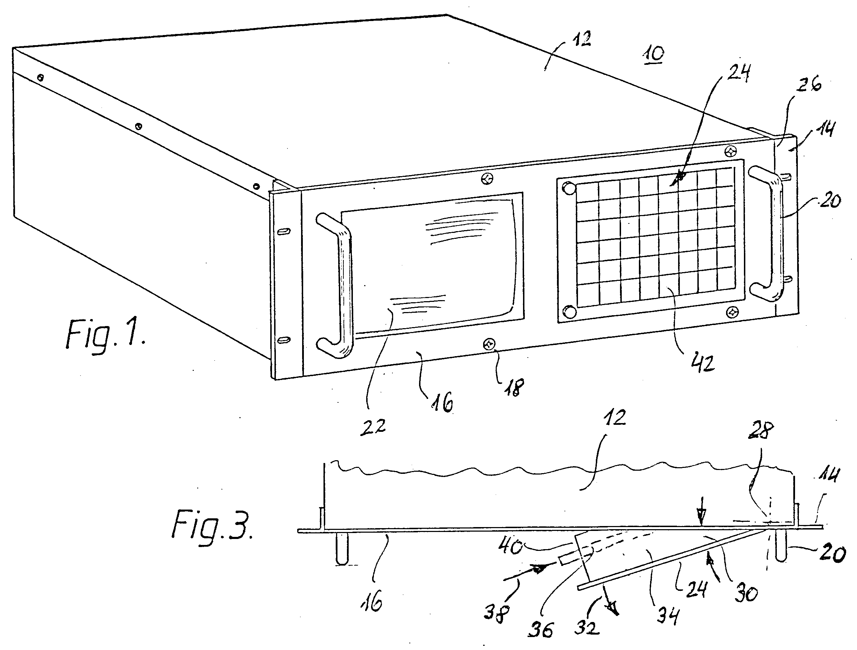

In Fig. 1 ist in perspektivischer Ansicht ein Einschubgehäuse, hier eine Computergehäuse 10 zu erkennen, mit einem Einschubteil 12, das in ein größeres Gehäuse eingeschoben und mittels Winkeln 14 festgelegt werden kann, und mit einer auch danach noch zugänglichen Frontplatte 16, die mit dem Einschubteil 12 beispielsweise mittels Schrauben 18 verschraubt ist und außerdem hier Handgriffe 20 aufweist, um das Einschubgehäuse 10 in das größere Gehäuse hineinzuschieben und es daraus herauszuziehen.

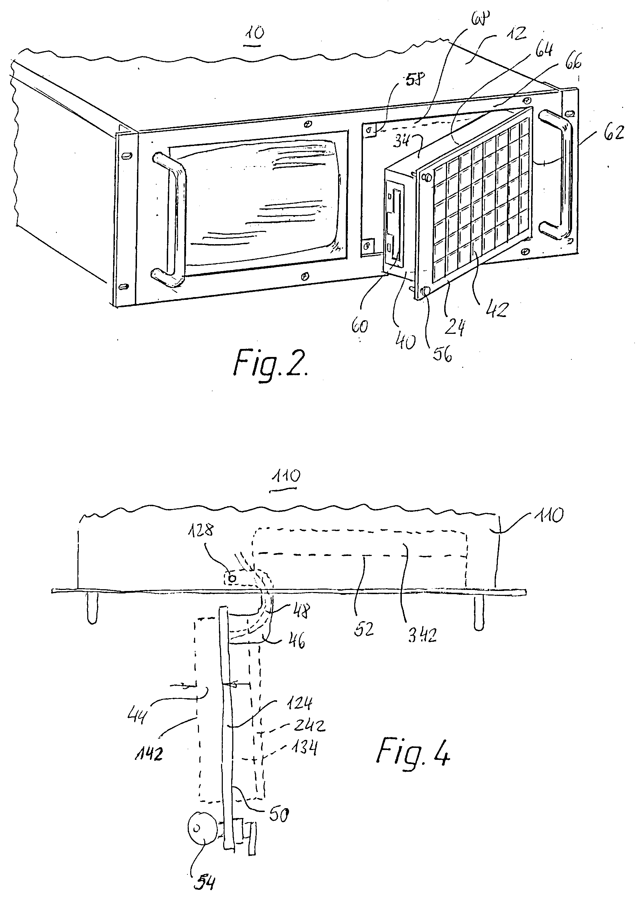

Die Frontplatte weist hier beispielsweise eine Sichtfläche 22 wie Bildschirm, auf, der Bereich kann aber auch eine Lüftungseinrichtung umfassen, wie es beispielsweise beim Stand der Technik der Fall ist. Die Frontplatte weist desweiteren eine türartige Zugangsabdeckung 24 auf, die, siehe Fig. 3, nahe der rechten Vertikalkante 26 der Frontplatte 16 in geeigneter Weise angelenkt ist, beispielsweise in einer Form, wie es beim Stand der Technik beschrieben ist und auch in Fig. 4 angedeutet wird. Durch diese Anlenkung 28 gelingt es, die türartige Zugangsabdeckung 24 aus einer Stellung, in der die Vorderfläche der türartigen Abdeckung 24 mit der Frontfläche der Frontplatte 16 fluchtet oder zumindest parallel zu ihr liegt, herauszuschwenken in eine Stellung, in der die türartige Abdeckung 24 bezüglich der Frontfläche 16 einen Winkel 30 bildet, der je nach Bedarf eine Größe annehmen kann, die zwischen etwa 30° und (wenn gewünscht) 180° liegen kann Bei der Darstellung gemäß Fig. 3 ist die türartige Abdeckung 24 in Richtung des Pfeiles 32 nur um einen Winkel 30 von annähernd 20° bis 30° herausgeschwenkt, was aber ausreicht, um Zugang zu einem flachen, rechteckigen Kasten 34 zu erhalten, der beispielsweise ein Datenspeicherlaufwerk darstellt, mit einem Einführschlitz 60 zum Einschieben eines Speichermediums, wie Diskette 36. Wie die Fig. 3 erkennen läßt, reicht diese geringfügige Ausschwenkung der türartigen Abdeckung 24 durchaus aus, um in Richtung des Pfeiles 38 die Diskette 36 in den mit einem Schlitz 60 auf der Seitenfläche 40 versehenen Kasten 34 einzuschieben. Läßt sich die Tür 24 weiter öffnen, wäre auch eine Einführung von oben oder unten in den Kasten möglich, jedoch ist diese Alternative weniger günstig, zum einen, weil eine weitere Ausschwenkbarkeit gewährleistet sein muß, desweiteren, weil dann, wenn das Einschubgehäuse sehr tief oder sehr hoch angeordnet ist, die Zugänglichkeit der beiden horizontalen Kastenseiten beeinträchtigt sein könnte, beispielsweise durch den Fußboden oder durch die Decke des Raumes, in dem ein Gestell angeordnet ist, in dem beispielsweise das Einschubgehäuse 10 eingeführt ist.

Die türartige Zugangsabdeckung 24 läßt nach dem Schließen den Einführschlitz der Fläche 40 hinter der Frontplatte 16 verschwinden, so daß auch hier, wie beim Stand der Technik, sichergestellt ist, daß Staub oder sonstige störende Teile (Büroklammern o. ä.) nicht in den Schlitz gelangen können.

Der flache Kasten 34 mit beispielsweise dem Laufwerk nimmt nur sehr wenig Tiefe innerhalb des Gehäuses 12 in Anspruch, so daß ein großer zusätzlicher Raum innerhalb des Gehäuses 12 für andere Zwecke zur Verfügung steht.

Fig. 1 läßt erkennen, daß die Vorderfläche 24, die hier für das Computerlaufwerk und den Einführungsschlitz nicht benötigt wird, für andere Zwecke eingesetzt werden kann, beispielsweise für ein Tastenfeld 42. Es können auch Anzeigeeinrichtungen hier untergebracht werden, ggf. auch Tasten sowie Anzeigeeinrichtungen gleichzeitig. Derartige Tasten und Anzeigeeinrichtungen können sehr flach sein, so daß sie, wie Fig. 2 erkennen läßt, wenig oder auch gar nicht über die Vorderfläche der türartigen Zugangsabdeckung 24 hervorragen. Dies muß aber nicht so sein, sondern man kann auch, ohne daß dies wesentlich stört, eine Anzeige- und Bedienungsplatte 142 auf oder anstatt der türartigen Abdeckung 124 in der Weise anordnen, siehe Fig. 4, daß diese Einrichtung 142 durchaus um ein Maß 44 vorsteht. Fig. 4 läßt auch erkennen, daß hier eine Ausschwenkbarkeit von 90° verwirklicht ist, mittels beispielsweise einer U-förmigen Scharniereinrichtung 46, wie sie beim Stand der Technik genauer beschrieben wird, wobei die elektrischen Verbindungen zwischen der Inneneinrichtung des Einschubgehäuses 110 und dem beispielsweise Tastenfeld 142 über eine Kabelverbindung 48 erfolgen könnte. Der Vorteil der Ausschwenkbarkeit um 90° (oder auch mehr) ist der, daß auch die Rückseite 50 der türartigen Abdeckung 124 zur Verfügung steht, beispielsweise, um nicht nur einen Kasten 134 (beispielsweise wieder mit einem Laufwerk) zu tragen, sondern auch ein weiteres Tasten- oder Anzeigefeld 242, das entweder auf der Rückseite 50 direkt, oder aber auf dem Kasten 134 angebracht sein kann. Gegenüber der Ausführungsform von Fig. 1 bis 3 steht hiermit somit nahezu die doppelte Fläche für die Unterbringung von Tasten, Schaltern, und Anzeigeeinrichtungen zur Verfügung.

Es ist klar, daß die von der türartigen Abdekkung 124 verdeckte Innenfläche 52 gleichfalls genutzt werden kann, wiederum um beispielsweise ein Tastenfeld unterzubringen, oder andere Bedienungselemente, insbesondere solche, die (aus beispielsweise Sicherungsgründen) nicht jederzeit zugänglich sein dürfen, sondern ebfalls von der türartigen Abdeckung 124 abgedeckt sein sollen, um unautorisierten Zugang dazu zu verhindern. Zu diesem Zweck kann die türartige Abdeckung 124 mit einem abschließbaren Verschluß 54 ausgestattet sein, ebenfalls wiederum wie beim Stand der Technik.

Damit hätte sich die Bedienungsfläche gegenüber der Grundform bereits verdreifacht.

In Fig. 2 ist die türartige Abdeckung 24 anstatt mit einem abschließbaren Vorreiberverschluß, wie bei Fig. 4 dargestellt, mit Hilfe von Rändelschrauben 56 in der geschlossenen Stellung sicherbar, welche Rändelschrauben in von dem Computergehäuse 12 gebildeten Gewindelappen 58 eingeschraubt werden können.

Bei der Abbildung gemäß der Fig. 2 ist auch der Einführschlitz 60 in der Fläche 40 des Kastens 34 zu erkennen, in die ein Speichermedium o. ä. eingeschoben werden kann, wenn sich die türartige Abdeckung 24 in einer geringfügig herausgeschwenkten Stellung befindet, wie in Fig. 2 zu erkennen ist.

Es ist klar, daß der Kasten 34 gemäß Fig. 2 selbst die türartige Abdeckung 24 mit einer seiner Wände bilden kann, so daß dann der Kasten 40 bzw. das Laufwerk ein Scharnier trägt, mit dem es an der Durchbruchskante 62, die durch die türartige Abdeckung 24 abgedeckt werden soll, angelenkt sein kann.

Die türartige Abdeckung 24 steht über dem Kasten 24 etwas über, so daß sich Schulterbreiche 64 ergeben, die mit Dichtungsstreifen versehen werden können, die mit Randbereichen 66 des Gehäuses 12 oder mit zurückspringenden Kanten 68 in Eingriff treten, wenn die türartige Zugangsabdeckung 24 in ihrer geschlossenen Stellung sich befindet, um so auch das seitliche Eindringen von Staub o. ä. zu unterbinden.

Selbstverständlich kann das Gehäuse 12 auch ein selbständiges Gehäuse sein, also keinen Einschub darstellen.

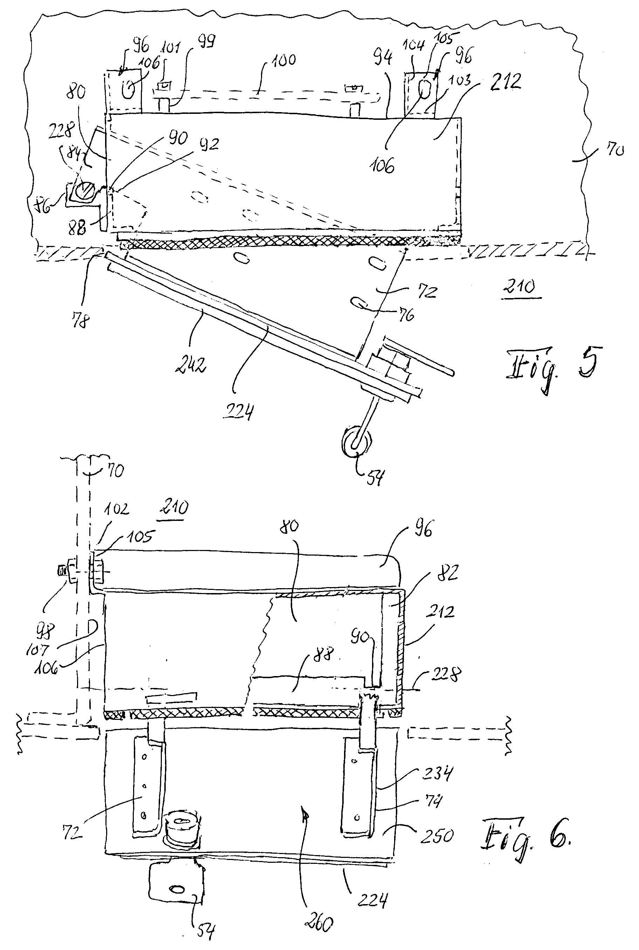

In Fig. 5 ist in einer Draufsicht ein Computergehäuse 210 gestrichelt dargestellt, an dem seinerseits ein Rahmen oder Gehäuse 212 montiert ist, beispielsweise auf einer Platte 70 des Gehäuses 210, siehe dazu auch die Fig. 6, eine Ansicht von rechts auf die Anordnung gemäß Fig. 5.

Bei der Ausführungsform gemäß Fig. 5 trägt die türartige Abdeckung 224 ein aus Folientasten gebildetes Tastenfeld 242, die nur wenig über die beispielsweise aus Stahlblech gebildete türartige Abdeckung 224 hinausragen. Die Platte 224 trägt an ihrer Rückseite Befestigungswinkel 72, 74, an denen ihrerseits z. B. ein Laufwerk oder dgl. befestigt oder angeordnet werden kann, zu welchem Zweck diese Befestigungswinkel beispielsweise mit Durchbrüchen 76 versehen sind, an denen beispielsweise ein Laufwerk angeschraubt werden kann.

Wie die Figuren weiterhin erkennen lassen, insbesondere die Fig. 5, dienen diese Befestigungswinkel aber auch dazu, die türartige Abdeckung 224 an dem Rahmen oder Gehäuse 212 anzulenken, siehe die Bezugszahl 228. Zu diesem Zweck reicht der Befestigungswinkel 72 bzw. 74 über den einen Rand 78 der Abdeckplatte 224 hinaus (und hier durch einen Durchbruch 80 in einer vom Rahmen oder Gehäuse 212 gebildeten Seitenwand 82 hindurch). An dem hindurch- und hinausreichenden Ende 84 befindet sich ein Durchbruch für das Hindurchführen einer Schraube 282, die ihrerseits in einem Anlenkwinkel 86 mit Durchbruch angeschraubt ist, welcher Anlenkwinkel 86 an dem unteren Ende 88 der (z. B. von dem Durchbruch 80 nicht erfaßten) Seitenwand 82 befestigt ist, beispielsweise durch Punktschweißung.

Beim Verschwenken der angelenkten Abdeckplatte um einen bestimmten Öffnungswinkel, der in Fig. 5 zu erkennen ist, schlägt die durch den Durchbruch durchreichende Erstreckung 84 des Befestigungswinkels 72 bzw. 74 mit einem Einschnittbereich 92 an einen Teil 90 des Durchbruchrandes an, wie aus den Fig. 5 und 6 deutlich hervorgeht, wodurch in einfacher Weise eine Schwenkbegrenzung für die türartige Abdeckung 224 erreicht wird. Der Anschlag kann natürlich auch woanders erfolgen, wenn ein Durchbruchrand nicht vorhanden ist, z. B. an einer von einem Einschnitt oder einem Rand der Seitenwand 82 gebildeten Kante.

Gleichzeitig ermöglicht diese außerhalb angeordnete Anlenkung 228, den gesamten innerhalb des Gehäuses 212 zur Verfügung stehenden Raum zu nutzen.

Wie aus den Fig. 5 und 6 hervorgeht, ist der Rahmen oder das Gehäuse 212 hier kastenartig, wobei die Außenfläche 94 des Kastenbodens Befestigungswinkel 96 zum Befestigen des insgesamt gebildeten Kastens 212 in einem größeren Gehäuse 210 ermöglicht, wie aus Fig. 6 insbesondere hervorgeht, siehe dort die Verschraubung 98.

Die Außenfläche des Kastenbodens kann auch angenietete Gewindehülsen 99 aufweisen, die kürzer sind als die von der Außenfläche 94 des Kastenbodens vorspringenden Teile der Befestigungswinkel 96, so daß es möglich wird, zwischen zwei nahe von sich gegenüberliegender Kastenränder angeordneten Befestigungswinkel 96, wie in Fig. 5 zu erkennen, mit Hilfe dieser Gewindehülsen 99 eine Printplatte 100 zu befestigen, beispielsweise mittels in den Gewindehülsen 99 eingeschraubten Schrauben 101. Durch die über die Printplattenebene vorstehenden Befestigungswinkel 96 werden diese Printplatte 100 und ggf. auch auf ihnen montierte Bauteile gegen Beschädigung geschützt, beispielsweise dann, wenn der Kasten 212 bei Wartungsarbeiten auf eine Auflagefläche gelegt wird, bei welcher Gelegenheit sich der Kasten 212 auf die am weitesten vorspringenden Kanten der Winkel 96 abstützen würde, so daß die Auflage nicht auf der Printplatte 100 oder deren Teile erfolgen wird.

Die Befestigungswinkel 96 können, wie Fig. 6 erkennen läßt, vorzugsweise langgestreckt sein und an ihrem einen Längsende 102 eine zu den beiden Winkelschenkeln 103, 104 querlaufende Abschlußwand 105 bilden, in der ein Durchbruch 106 für einen Befestigungsbolzen 98 vorgesehen ist.

Die Ebene der Abschlußwand 105 ist vorzugsweise jenseits der entsprechenden Kastenseite 106 angeordnet, so daß sich ein gewisser Abstand zwischen dieser Kastenseite 106 und der Befestigungsfläche 107 der Platte 70 des Gehäuses 210 ergibt, um beispielsweise Belüftungsmöglichkeiten zu haben, oder um in diesen Zwischenraum weitere Bauteile unterzubringen.

**Patentansprüche**

1. Computergehäuse (10), insbesondere Einschubgehäuse mit türartiger Zugangsabdeckung (24) für ein Datenspeicherlaufwerk oder dgl., wobei die türartige Zugangsabdeckung (24) aus einer im wesentlichem rechteckigen Platte besteht, die an einer Rechteckkante am Computergehäuse (10), insbesondere Frontseite eines Einschubgehäuses (12) ausschwenkbar angelenkt ist (28), und an einer anderen, wie gegenüberliegenden Kante am Computergehäuse einrastbar oder verriegelbar (54; 56) ist, dadurch gekennzeichnet, daß das Datenspeicherlaufwerk oder dgl. einen im wesentlichen flachen, rechteckigen Kasten (34) mit einem Einführschlitz (60) für eine Diskette oder dgl. bildet, daß der Kasten (34) auf der Hinterfläche (50) der türartigen Zugangsabdeckung (24) angeordnet oder diese von dem Kasten gebildet wird, und daß der Einführschlitz (60) an einer von der angelenkten Seite der Abdeckung abgewandten, vorzugsweise einer gegenüberliegenden Seite angeordnet ist.

2. Computergehäuse nach Anspruch 1, dadurch gekennzeichnet, daß die Anlenkungsachse (28) der türartigen Abdeckung (24) parallel und nahe zu einer der Vertikalfrontkanten (26) liegt und der Einführschlitz (60) parallel zu dieser Achse (28) und von dieser Achse weggerichtet liegt.

3. Computergehäuse nach Anspruch 1 oder 2, dadurch gekennzeichnet, daß die türartige Abdeckung (24, 124) zumindest um einen solchen Winkel (30, Fig. 3) um die Anlenkungsachse (28) aus einer zur Gehäusefrontfläche parallelen Stellung ausschwenkbar ist, so daß der Schlitz (60) vor die Gehäuseaußenebene zu liegen kommt.

4. Computergehäuse nach einem der Ansprüche 1 bis 3, dadurch gekennzeichnet, daß die Außenfläche der türartigen Abdeckung (124) Bedienungs- und/oder Anzeigeeinrichtungen (42) trägt, wie ein Leucht- oder Tastenfeld.

5. Computergehäuse nach einem der Ansprüche 1 bis 4, dadurch gekennzeichnet, daß die nach innen weisende Fläche des Kastens (34) ebenfalls Bedienungs- und/oder Anzeigeeinrichtungen (242) aufweist.

6. Computergehäuse nach einem der Ansprüche 1 bis 5, dadurch gekennzeichnet, daß die von der türartigen Abdeckung (24, 124) abgedeckte Innenfläche innerhalb des Computergehäuses (110) gleichfalls Bedienungs- und/oder Anzeigeeinrichtungen (342) trägt.

7. Computergehäuse, insbesondere Einschubgehäuse mit türartiger Zugangsabdeckung (124) für ein Datenspeicherlaufwerk oder dgl., wobei die türartige Zugangsabdeckung (124) aus einer im wesentlichen rechteckigen Platte besteht, die parallel zu einer Rechteckkante der Platte am Computergehäuse, insbesondere zu einer Frontseitenkante eines Einschubgehäuses, ausschwenkbar angelenkt ist (28, 128), und an einer anderen, wie gegenüberliegenden Kante am Computergehäuse einrastbar oder verriegelbar (54, 56) ist, dadurch gekennzeichnet, daß die Außenfläche der türartigen Abdeckung (124) Bedienungs- und/oder Anzeigeeinrichtungen (142), wie ein Leuchten- oder Tastenfeld trägt.

8. Computergehäuse nach Anspruch 7, dadurch gekennzeichnet, daß auch die Rückseite (50) der türartigen Abdeckung (124) Bedienungs- und/oder Anzeigeeinrichtungen (124) trägt.

9. Computergehäuse nach Anspruch 7 oder 8, dadurch gekennzeichnet, daß auch ein von der türartigen Abdeckung (124) abdeckbarer innerer Bereich des Gehäuses (52) Bedienungs- und/oder Anzeigeeinrichtungen (342) trägt.

10. Computergehäuse nach Anspruch 7, 8 oder 9, dadurch gekennzeichnet, daß auf der Rückseite (50) der türartigen Abdeckung (124) ein flacher Kasten (134) mit beispielsweise einem Laufwerk angeordnet ist, der seinerseits an seiner Außenfläche Bedienungs- und/oder Anzeigeeinrichtungen (242) trägt.

11. Computergehäuse nach Anspruch 7, dadurch gekennzeichnet, daß das Tastenfeld (224) von Folientasten gebildet wird.

12. Computergehäuse nach einem der Ansprüche 7 bis 10, dadurch gekennzeichnet, daß auf der Rückseite der türartigen Abdeckung (224) ein (oder mehrere) Befestigungswinkel (72, 74) zur Befestigung von Laufwerken oder dgl. angeordnet ist oder sind.

13. Computergehäuse nach Anspruch 12, dadurch gekennzeichnet, daß die türartige Abdeckung (224) mittels dieser Befestigungswinkel (72, 74) an einem Rahmen oder Gehäuse (212) angelenkt ist.

14. Computergehäuse nach Anspruch 13, dadurch gekennzeichnet, daß die Befestigungswinkel (72, 74) über den einen Rand (78) der türartigen Abdeckung (224) hinausreichen (und ggf. durch einen (jeweiligen) Durchbruch (80), der sich in einer vom Rahmen oder Gehäuse (212) gebildeten, die Anlenkung (86) tragenden Seitenwand (80, 88) gebildet wird, hindurchreichen), und an ihrem (ggf. durch den Durchbruch hindurchreichendem) Ende (84) an von z. B. der oder einer Seitenwand (88) ausgehenden Anlenkwinkeln (86) angelenkt (228) sind.

15. Computergehäuse nach Anspruch 14, dadurch gekennzeichnet, daß beim Verschwenken der angelenkten türartigen Abdeckung (224) um einen bestimmten Winkel in Öffnungsrichtung die durch den Durchbruch (80) (oder einer Einsenkung einer Seitenwand) hindurchreichenden Teile (92) der Befestigungswinkel (72, 74) an einen Rand (90) des Durchbruches (80) (oder der Einsenkung) anschlagen.

16. Computergehäuse nach einem der Ansprüche 13 bis 15, dadurch gekennzeichnet, daß der Rahmen oder das Gehäuse (212) kastenartig ist, wobei die Außenfläche (94) des Kastenbodens Befestigungswinkel (96) zum Befestigen des kastenartigen Gehäuses in einem anderen, größeren Gehäuse (210) trägt.

17. Computergehäuse nach Anspruch 16, dadurch gekennzeichnet, daß die Außenfläche (94) das Kastenbodens angenietete Gewindehülsen (99) trägt, die kürzer sind als die von der Außenfläche (94) des Kastenbodens vorspringenden Teile der Befestigungswinkel (96), wobei die Gewindehülsen vorzugsweise zwischen zwei, nahe sich gegenüberliegenden Tastenrändern angeordneten, Befestigungswinkel (96) zum Befestigen von Printplatten (100) vorgesehen sind.

18. Computergehäuse nach Anspruch 16 oder 17, dadurch gekennzeichnet, daß die Befestigungswinkel (96) langgestreckt sind und an ihrem einen Längsende (102) eine zu den beiden Winkelschenkeln (103, 104) querlaufende Abschlußwand (105) bilden, in der ein Durchbruch (106) für einen Befestigungsbolzen (98) vorgesehen ist.

19. Computergehäuse nach Anspruch 18, dadurch gekennzeichnet, daß die Ebene der Abschlußwand (105) jenseits der zugehörigen Tastenseite (106) liegt.

Fig.1.

Fig.3.

Fig.2.

Fig.4

Fig. 5

Fig. 6.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A,D | DE-U-9 000 854 (TAPPERT KARL-HEINZ)<br>* das ganze Dokument * | 1 | G11B33/12<br>G06F1/16<br>H05K7/14 |
| | --- | | |
| A | EP-A-0 198 093 (FANUC LTD)<br>* das ganze Dokument * | 1 | |
| | --- | | |
| A | ELEKTRONIK.<br>Bd. 33, Nr. 6, 23. März 1984, MUNCHEN DE<br>Seiten 125 - 127; 'Wirtschaftlicher produzieren'<br>* das ganze Dokument * | 1 | |
| | ----- | | **RECHERCHIERTE SACHGEBIETE (Int. Cl.5)**<br><br>G11B<br>G06F<br>H05K<br>G05B |

Der vorliegende Recherchenbericht wurde für alle Patentansprüche erstellt

| Recherchenort | Abschlußdatum der Recherche | Prüfer |
|---|---|---|
| DEN HAAG | 10 JULI 1992 | TOUSSAINT F.M.A. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
..............................................................................
& : Mitglied der gleichen Patentfamilie, übereinstimmendes
    Dokument